# EUROPÄISCHE PATENTANMELDUNG

(11) **EP 1 113 453 A2**
(43) Veröffentlichungstag der Anmeldung: **04.07.2001**
(21) Anmeldenummer: 00123917.7
(22) Anmeldetag: 03.11.2000
(51) Int. Cl.: G11C 29/00

(54) **Speichereinrichtung**

(30) Priorität: 11.11.1999 DE 19954346
(71) Anmelder: Infineon Technologies AG, 81669 München (DE)
(72) Erfinder: Sellmair, Gerald, 84036 Landshut (DE)
(74) Vertreter: Jannig, Peter, Dipl.-Ing.

(57) **Zusammenfassung**

Die Speichereinrichtung enthält Vergleichseinheiten, durch welche überprüfbar ist, ob einer an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt. Die Vergleichseinheiten lassen sich während des Testens der Speichereinrichtung in einen Zustand versetzen, der sich von dem Zustand, den die Vergleichseinheiten während des normalen Betriebes der Speichereinrichtung innehaben, unterscheidet.

## Beschreibung

Die vorliegende Erfindung betrifft eine Vorrichtung gemäß dem Oberbegriff des Patentanspruchs 1, d.h. eine Speichereinrichtung mit einer Vielzahl von Speicherzellen zum Speichern von Daten, und mit Vergleichseinheiten, durch welche überprüfbar ist, ob einer an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt.

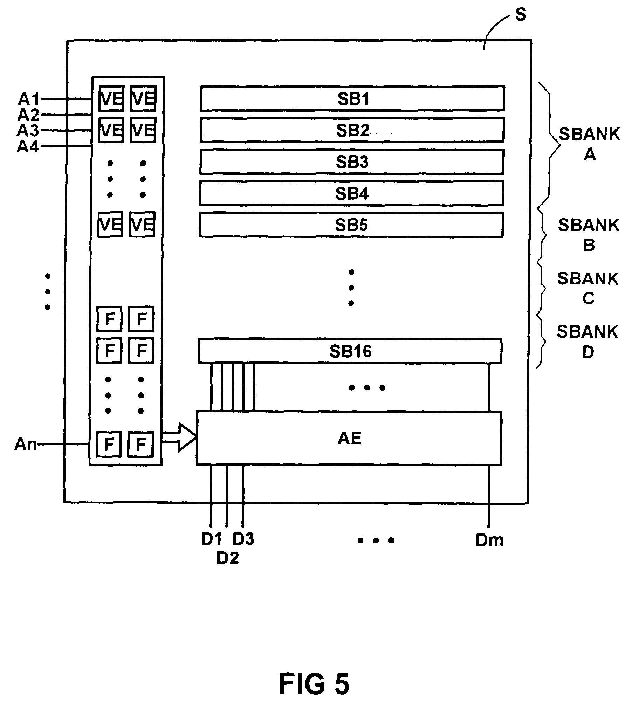

Eine Speichereinrichtung dieser Art ist schematisch in der Figur 5 dargestellt. Der Vollständigkeit halber sei darauf hingewiesen, daß in der Figur 5 nur die vorliegend besonders interessierenden Bestandteile der Speichereinrichtung gezeigt sind.

Die Speichereinrichtung ist in der Figur 5 mit dem Bezugszeichen S bezeichnet.

Die Speichereinrichtung S ist im betrachteten Beispiel zur Speicherung von 16 MBit Daten ausgelegt, weist also mindestens 16M Speicherzellen auf. Die vorhandenen Speicherzellen sind im betrachteten Beispiel auf 16 gleich große, also in zur Speicherung von jeweils 1 MBit Daten ausgelegte Speicherblöcke SB1 bis SB16 verteilt. Diese Speicherblöcke SB1 bis SB16 sind im betrachteten Beispiel wiederum auf vier gleich große Speicherbänke SBankA, SBankB, SBankC, und SBankD verteilt.

Die Speicherzellen eines jeden Speicherblocks sind im betrachteten Beispiel in einer 512 Zeilen und 2048 Spalten umfassenden Speicherzellen-Matrix angeordnet, also über 512 Wortleitungen und 2048 Bitleitungen ansprechbar. Die Maßnahmen, die im einzelnen zu ergreifen sind, um ausgewählte Speicherzellen zu beschreiben oder auszulesen, sind allgemein bekannt und bedürfen keiner näheren Erläuterung.

Die jeweils zu beschreibenden oder auszulesen Speicherzellen werden durch eine an die Speichereinrichtung angelegte, genauer gesagt an Anschlüsse A1 bis An derselben angelegte Adresse bestimmt; die Daten, die in die betreffenden Speicherzellen einzuschreiben sind, bzw. die aus den betreffenden Speicherzellen auszulesen sind, werden an Anschlüsse D1 bis Dm der Speichereinrichtung angelegt bzw. zur Abholung bereitgestellt.

Die betrachtete Speichereinrichtung weist mehr als die 16M Speicherzellen auf, die erforderlich sind, um 16 MBit Daten zu speichern. Dies wird gemacht, um nicht ordnungsgemäß beschreibbare oder auslesbare Speicherzellen oder Speicherzellenbereiche durch andere Speicherzellen oder Speicherzellenbereiche ersetzen zu können.

Die Speicherzellen oder Speicherzellenbereiche, die nicht ordnungsgemäß beschreibbar oder auslesbar sind, genauer gesagt die diesen Speicherzellen oder Speicherzellenbereichen zugeordneten Adressen werden bei einem Test der Speichereinrichtung ermittelt und beispielsweise unter Verwendung von sogenannten Fuses F in der Speichereinrichtung registriert.

Im normalen Betrieb der Speichereinrichtung werden die über die Anschlüsse A1 bis An der Speichereinrichtung an diese angelegten Adressen mit den in der Speichereinrichtung registrierten Adressen der nicht ordnungsgemäß beschreibbaren oder auslesbaren Speicherzellen oder Speicherzellenbereiche durch Vergleichseinheiten VE verglichen. Wenn sich bei einem solchen Vergleich eine Übereinstimmung ergibt, so wird dies einer Auswahleinrichtung AE signalisiert, und diese sorgt dafür, daß in die Speichereinrichtung einzuschreibende Daten nicht etwa in die Speicherzellen eingeschrieben werden, die durch die an die Speichereinrichtung angelegte Adresse bezeichnet werden, sondern in den nicht verwendbaren Speicherzellen zugeordnete (Ersatz-)Speicherzellen, bzw. daß aus der Speichereinrichtung auszulesende Daten nicht etwa aus den Speicherzellen ausgelesen werden, die durch die an die Speichereinrichtung angelegte Adresse bezeichnet werden, sondern aus den nicht verwendbaren Speicherzellen zugeordnete (Ersatz-)Speicherzellen.

Auf die beschriebene Art und Weise können Speichereinrichtungen, in welchen nicht alle Speicherzellen ordnungsgemäß beschreibbar und auslesbar sind, wie völlig fehlerfreie Speichereinrichtungen verwendet werden; der Benutzer der Speichereinrichtung merkt nichts davon, daß bestimmte Speicherzellen oder Speicherzellenbereiche durch Ersatz-Speicherzellen oder Ersatz-Speicherzellenbereiche ersetzt werden.

Das Testen, Konfigurieren, und Betreiben von Speichereinrichtungen dieser Art ist jedoch mit einem hohen Aufwand verbunden, und zudem nicht unter allen Umständen fehlerfrei durchführbar.

Der vorliegenden Erfindung liegt daher die Aufgabe zugrunde, die Speichereinrichtung gemäß dem Oberbegriff des Patentanspruchs 1 derart weiterzubilden, daß sich die Speichereinrichtung mit minimalem Aufwand zuverlässig testen, konfigurieren und betreiben läßt.

Diese Aufgabe wird erfindungsgemäß durch das im kennzeichnenden Teil des Patentanspruchs 1 beanspruchte Merkmal gelöst.

Demnach ist vorgesehen, daß die Vergleichseinheiten während des Testens der Speichereinrichtung in einen Zustand versetzbar sind, der sich von dem Zustand, den die Vergleichseinheiten während des normalen Betriebes der Speichereinrichtung innehaben, unterscheidet.

Dadurch ist es möglich, die Speichereinrichtung mit minimalem Aufwand in einem bislang nicht möglichen Umfang zu testen. Dieser umfangreiche Test ermöglichte es, alle, insbesondere auch in den Vergleichseinheiten vorhandene Fehler zuverlässig zu erkennen. Dies wiederum ermöglicht es, die Speichereinrichtung optimal zu konfigurieren und absolut fehlerfrei zu betreiben.

Die Speichereinrichtung kann so mit minimalem Aufwand zuverlässig getestet, konfiguriert und betrieben werden.

Vorteilhafte Weiterbildungen der Erfindung sind den Unteransprüchen, der folgenden Beschreibung und den Figuren entnehmbar.

Die Erfindung wird nachfolgend anhand eines Ausführungsbeispiels unter Bezugnahme auf die Zeichnung näher erläutert. Es zeigen
- Figur 1: den Aufbau von in der nachfolgend näher beschriebenen Speichereinrichtung vorgesehenen Vergleichseinheiten zum Vergleich von der Speichereinrichtung zugeführten Adressen mit Adressen von nicht ordnungsgemäß beschreibbaren oder auslesbaren Speicherzellen,
- Figur 2: den Aufbau einer Aktivierungs-/Deaktivierungseinrichtung, durch welche die Vergleichseinheiten gemäß Figur 1 selektiv aktivierbar und deaktivierbar sind,
- Figur 3: die Verwendung des Ausgangssignals der Aktivierungs-/Deaktivierungseinrichtung gemäß Figur 2 zur Aktivierung und Deaktivierung der Vergleichseinheiten,
- Figur 4: eine Referenzadreß-Auswahleinrichtung, durch welche festlegbar ist, mit welcher von mehreren möglichen Adressen die Vergleichseinrichtungen die an die Speichereinrichtung angelegte Adresse vergleichen sollen, und
- Figur 5: den prinzipiellen Aufbau einer Speichereinrichtung der vorliegend betrachteten Art.

Bei der vorliegend betrachteten Speichereinrichtung handelt es sich um einen RAM-Baustein, genauer gesagt um einen DRAM-Baustein. Es sei jedoch bereits an dieser Stelle darauf hingewiesen, daß hierauf keine Einschränkung besteht. Die Speichereinrichtung kann auch eine beliebige andere Speichereinrichtung zum Speichern von Daten sein.

Die nachfolgend näher beschriebene Speichereinrichtung hat den selben prinzipiellen Aufbau wie die eingangs unter Bezugnahme auf Figur 5 beschriebene Speichereinrichtung.

Die betrachtete Speichereinrichtung weist auch wieder mehr Speicherzellen auf, als zur Speicherung einer der verwendbaren Speicherkapazität entsprechenden Datenmenge erforderlich sind, wobei die zusätzlichen Speicherzellen als Ersatz-Speicherzellen oder Ersatz-Speicherzellenbereiche für nicht ordnungsgemäß beschreibbare oder auslesbare Speicherzellen oder Speicherzellenbereiche verwendbar sind.

Die nicht ordnungsgemäß beschreibbaren oder auslesbaren Speicherzellen oder Speicherzellenbereiche werden durch einen Test der Speicherzellen ermittelt. Die Adressen dieser Speicherzellen oder Speicherzellenbereiche werden unter Verwendung von Fuses, im betrachteten Beispiel unter Verwendung von durch einen Laser zerstörbaren Fuses F in der Speichereinrichtung registriert.

Im normalen Betrieb der Speichereinrichtung werden die an diese angelegten Adressen unter Verwendung der Vergleichseinheiten VE mit den in der Speichereinrichtung registrierten Adressen der nicht ordnungsgemäß beschreibbaren oder auslesbaren Speicherzellen oder Speicherzellenbereiche verglichen; die Vergleichseinheiten VE verwenden die Adressen der nicht ordnungsgemäß beschreibbaren oder auslesbaren Speicherzellen oder Speicherzellenbereiche als Referenzadressen, mit denen sie die an die Speichereinrichtung angelegten Adressen vergleichen.

Stellt eine Vergleichseinheit eine Übereinstimmung der zu vergleichenden Adressen fest, so signalisiert sie dies der Auswahleinrichtung AE, welche daraufhin dafür sorgt, daß in die Speichereinrichtung einzuschreibende Daten nicht etwa in die Speicherzellen eingeschrieben werden, die der an die Speichereinrichtung angelegten Adresse zugeordnet sind, sondern in den nicht verwendbaren Speicherzellen zugeordnete (Ersatz-)Speicherzellen, bzw. daß aus der Speichereinrichtung auszulesende Daten nicht etwa aus den Speicherzellen ausgelesen werden, die der an die Speichereinrichtung angelegten Adresse zugeordnet sind, sondern aus den nicht verwendbaren Speicherzellen zugeordneten (Ersatz-)Speicherzellen.

Im betrachteten Beispiel sind pro Speicherblock 16 Vergleichseinheiten vorgesehen. Diese Vergleichseinheiten sind dabei auf je vier Vergleichseinheiten umfassende Vergleichseinheiten-Bänke aufgeteilt. Wie später noch näher erläutert wird, werden die Vergleichseinheiten-Bänke vorliegend jeweils einem bestimmten Speicherblock zugeordnet.

Es sei bereits an dieser Stelle darauf hingewiesen, daß auch mehr oder weniger Vergleichseinheiten vorgesehen werden können, und daß die Vergleichseinheiten auch auf mehr oder weniger Vergleichseinheiten umfassende Vergleichseinheiten-Bänke oder überhaupt nicht auf Vergleichseinheiten-Bänke aufgeteilt werden können.

Jeder Vergleichseinheit ist eine eigene Referenzadresse zugeordnet.

Die vorhandenen Vergleichseinheiten arbeiten parallel, so daß die an die Speichereinrichtung angelegten Adressen jeweils gleichzeitig durch alle Vergleichseinheiten mit den diesen zugeordneten Referenzadressen, also gleichzeitig mit allen Referenzadressen verglichen werden.

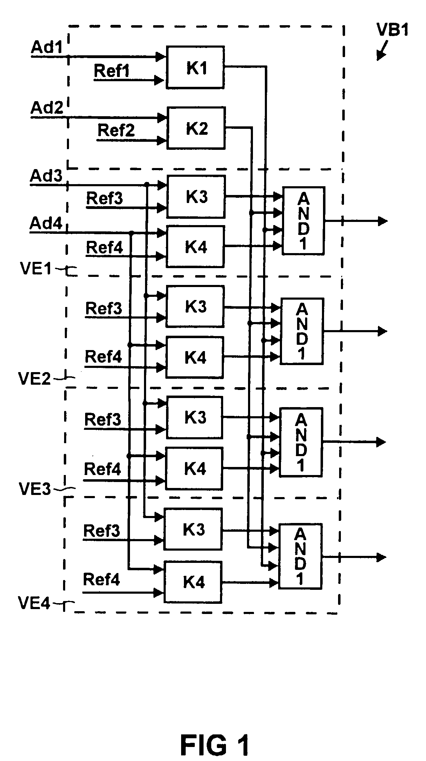

Eine aus vier Vergleichseinheiten bestehende Vergleichseinheiten-Bank ist in Figur 1 dargestellt.

Die Vergleichseinheiten sind dabei mit den Bezugszeichen VE1, VE2, VE3 und VE4 bezeichnet, und die diese Vergleichseinheiten enthaltende Vergleichseinheiten-Bank mit den Bezugszeichen VB1.

Die Vergleichseinheiten-Bank VB1 enthält neben den Vergleichseinheiten VE1 bis VE4 zwei Komparatoren K1 und K2, wobei
- der Komparator K1 überprüft, ob die Speicherbank, die durch die der Speichereinrichtung zugeführte Adresse angesprochen wird, die Speicherbank ist, in welcher sich der Speicherblock befindet, dem die betreffende Vergleichseinheiten-Bank (durch die Referenzadressen, die den darin enthaltenen Vergleichseinheiten zugeordnet sind) zugeordnet ist, und
- der Komparator K2 überprüft, ob der Speicherblock (innerhalb einer Speicherbank), der durch die der Speichereinrichtung zugeführte Adresse angesprochen wird, der Speicherblock ist, dem die betreffende Vergleichseinheiten-Bank (durch die Referenzadressen, die den darin enthaltenen Vergleichseinheiten zugeordnet sind) zugeordnet ist.

Die Vergleichseinheiten VE1 bis VE4 weisen einen identischen Aufbau auf. Wie später noch besser verstanden werden wird, ist dies zwar nicht zwingend erforderlich und verursacht sogar einen größeren Aufwand bei der Herstellung der Speichereinrichtung, doch lassen sich so aufgebaute Speichereinrichtungen mit minimalem Aufwand entwerfen, modifizieren und testen.

Die Vergleichseinheiten VE1 bis VE4 enthalten jeweils Komparatoren K3 und K4 und ein UND-Glied AND1, wobei
- die Komparatoren K3 jeweils überprüfen, ob die Speicherzellen-Spalten, die der der Speichereinrichtung zugeführten Adresse zugeordnet sind, die Speicherzellen-Spalten sind oder sich zumindest teilweise unter den Speicherzellen-Spalten befinden, die der der betreffenden Vergleichseinheit zugeordneten Referenzadresse zugeordnet sind,
- die Komparatoren K4 jeweils überprüfen, ob die Speicherzellen-Zeile, die der der Speichereinrichtung zugeführten Adresse zugeordnet ist, die Speicherzellen-Zeile ist oder sich unter den Speicherzellen-Zeilen befindet, die der der betreffenden Vergleichseinheit zugeordneten Referenzadresse zugeordnet ist bzw. sind, und
- die UND-Glieder AND1 die Ausgangssignale der in den betreffenden Vergleichseinheiten vorgesehenen lokalen Komparatoren K3 und K4 sowie die Ausgangssignale der globalen Komparatoren K1 und K2 einer UND-Operation unterzieht.

Die Ausgangssignale der UND-Glieder AND1 zeigen an, ob die an die Speichereinrichtung angelegte Adresse mit der betreffenden Vergleichseinheit zugeordneten Referenzadresse übereinstimmt. Eine festgestellte Übereinstimmung signalisiert, daß eine an die Speichereinrichtung angelegte Adresse eine Speicherzelle bezeichnet, die nicht ordnungsgemäß beschreibbar oder auslesbar ist oder in einem nicht ordnungsgemäß beschreibbare oder auslesbare Speicherzellen enthaltenden Speicherzellenbereich liegt.

Die Die Ausgangssignale aller UND-Glieder AND1 einer jeweiligen Vergleichseinheiten-Bank werden einer in den Figuren nicht gezeigten Logik zugeführt, und deren Ausgangssignal steuert die bereits erwähnte Auswahleinrichtung AE, welche bei Bedarf dafür sorgt, daß auf den nicht verwendbaren Speicherzellen zugeordnete Ersatz-Speicherzellen zugegriffen wird; die Auswahleinrichtung AE wird veranlaßt, unbrauchbare Speicherzellen oder Speicherzellenbereiche durch Ersatz-Speicherzellen oder Ersatz-Speicherzellenbereiche zu ersetzen, wenn eines der AND1-Ausgangssignale signalisiert, daß die betreffende Vergleichseinheit eine Übereinstimmung zwischen der der Speichereinrichtung zugeführten Adresse und der der Vergleichseinheit zugeordneten Referenzadresse festgestellt hat, und die Auswahleinrichtung AE wird nicht dazu veranlaßt, Speicherzellen- oder Speicherzellenbereich-Ersetzungen durchzuführen, wenn keine Übereinstimmung zwischen den durch die Vergleichseinheiten zu vergleichenden Adressen festgestellt wurde.

Die bereits erwähnten Komparatoren K1 bis K4 erhalten als Eingangssignale Ad1 und Ref1 (Komparator K1), Ad2 und Ref2 (Komparator K2), Ad3 und Ref3 (Komparator K3), bzw. Ad4 und Ref4 (Komparator K4), wobei
- Ad1 bis Ad4 Teile der an die Speichereinrichtung angelegten Adresse sind oder daraus extrahiert werden,
- Ref1 bis Ref3 Teile der den Vergleichseinheiten zugeordneten Referenzadressen sind oder daraus extrahiert werden, und im betrachteten Beispiel unter Verwendung von Fuses F in der Speichereinrichtung eingestellt sind, und
- Ref4 ein Teil der den Vergleichseinheiten zugeordneten Referenzadressen ist oder daraus extrahiert wird, und im betrachteten Beispiel bei der Herstellung der Speichereinrichtung fest (unveränderbar) in der Speichereinrichtung eingestellt wird.

Die Eingangssignale Adl und Refl spezifizieren die Speicherbank, auf die sich die Adressen jeweils beziehen, und umfassen im betrachteten Beispiel jeweils 2 Bits (weil die betrachtete Speichereinrichtung vier Speicherbänke umfaßt oder umfassen kann).

Die Eingangssignale Ad2 und Ref2 spezifizieren den Speicherblock innerhalb der ausgewählten Speicherbank, auf den sich die Adressen jeweils beziehen, und umfassen im betrachteten Beispiel ebenfalls jeweils 2 Bits (weil die Speicherbänke im betrachteten Beispiel jeweils 4 Speicherblöcke umfassen oder umfassen können).

Die Eingangssignale Ad3 und Ref3 spezifizieren die Speicherzellen-Spalten, die den Adressen zugeordnet sind, und umfassen im betrachteten Beispiel ebenfalls jeweils 2 Bits, genauer gesagt die zwei höchstwertigen Bits der Spaltenadressen.

Die Eingangssignale Ad4 und Ref4 spezifizieren die Speicherzellen-Zeile(n), die den Adressen zugeordnet sind, und umfassen im betrachteten Beispiel ebenfalls jeweils 2 Bits, genauer gesagt die zwei höchstwertigen Bits der Zeilenadressen.

Die Eingangssignale Ref4 sind im betrachteten Beispiel so eingestellt, daß unabhängig von der der Speichereinrichtung zugeführten Adresse jeweils genau ein Komparator K4 einer jeden Vergleichseinheiten-Bank eine Übereinstimmung signalisiert, also beispielsweise auf 00 für VE1, auf 01 für VE2, auf 10 für VE3, und auf 11 für VE4..

Dadurch, daß bei den durchzuführenden Vergleichen von den Spaltenadressen und von den Zeilenadressen nur jeweils die zwei höchstwertigen Bits berücksichtigt werden, wird bei den Vergleichen "nur" überprüft, ob die an die Speichereinrichtung angelegte Adresse eine Speicherzelle bezeichnet, die innerhalb eines nicht ordnungsgemäß beschreibbare oder auslesbare Speicherzellen enthaltenden Speicherzellenbereichs liegt. Im betrachteten Beispiel werden also nicht etwa nur einzelne Speicherzellen durch Ersatz-Speicherzellen ersetzt, sondern mehr oder weniger große Speicherzellenbereiche durch Ersatz-Speicherzellenbereiche.

Die Vergleichseinheiten sind während des Testens der Speichereinrichtung in einen Zustand versetzbar, der sich von dem Zustand, den die Vergleichseinheiten während des normalen Betriebes der Speichereinrichtung innehaben, unterscheidet.

Die Unterschiede bestehen insbesondere darin,
- daß während des Testens der Speichereinrichtung unabhängig von den im normalen Betrieb der Speichereinrichtung herrschenden Verhältnissen ausgewählte Vergleichseinheiten aktiviert werden, und alle anderen Vergleichseinheiten deaktiviert werden, und/oder
- daß während des Testens der Speichereinrichtung die an diese angelegten Adressen mit Referenzadressen verglichen werden können, die von den im normalen Betrieb der Speichereinrichtung verwendeten Referenzadressen abweichen.

Die hierfür erforderlichen Umstellungen in den Vergleichseinheiten werden durch ein den Vergleichseinheiten zugeführtes Steuersignal TEST eingeleitet.

Dieses Steuersignal TEST steuert unter anderem eine oder mehrere Aktivierungs-/Deaktivierungseinrichtungen zum selektiven Aktivieren bzw. Deaktivieren der vorhandenen Vergleichseinrichtungen.

Im betrachteten Beispiel enthält jede Vergleichseinheit eine Aktivierungs-/Deaktivierungseinrichtung. Sofern alle Vergleichseinheiten einer Vergleichseinheiten-Bank einheitlich behandelt werden sollen, kann aber auch vorgesehen werden, für alle Vergleichseinheiten einer Vergleichseinheiten-Bank eine gemeinsame Aktivierungs-/Deaktivierungseinrichtung vorzusehen.

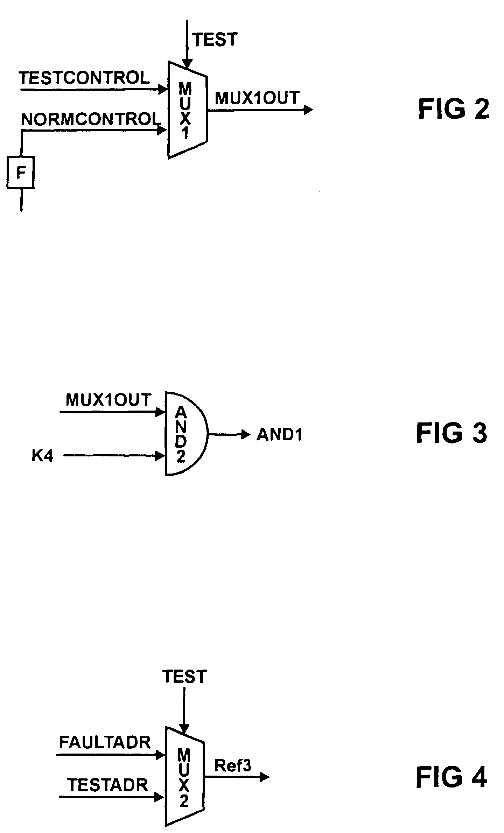

Eine der Aktivierungs-/Deaktivierungseinrichtungen ist in Figur 2 gezeigt.

Wie aus der Figur 2 ersichtlich ist, besteht die Aktivierungs-/Deaktivierungseinrichtung aus einem Multiplexer MUX1, der abhängig vom Steuersignal TEST entweder ein Eingangssignal TESTCONTROL oder ein Eingangssignal NORMCONTROL durchschaltet. Das Ausgangssignal MUX1OUT des Multiplexers MUX1 wird - sofern die Aktivierungs-/Deaktivierungseinrichtung nicht ohnehin schon Bestandteil der Vergleichseinheiten ist-den Vergleichseinheiten zugeführt, welche abhängig von diesem Signal aktivierbar oder deaktivierbar sind.

Im betrachteten Beispiel ist die Aktivierungs-/Deaktivierungseinrichtung so konfiguriert, daß der Multiplexer MUX1 im Normalbetrieb der Speichereinrichtung, was vorliegend bei TEST = 0 der Fall sein möge, das Signal NORMCONTROL durchschaltet, und im Testbetrieb der Speichereinrichtung, was vorliegend bei TEST = 1 der Fall sein möge, das Signal TESTCONTROL durchschaltet.

Sowohl das Signal TESTCONTROL als auch das Signal NORMCONTROL können wahlweise den Pegel 0 oder 1 annehmen.

Im betrachteten Beispiel ist die das Signal TESTCONTROL führende Leitung bei der Herstellung der Speichereinrichtung dauerhaft mit einem einen niedrigen Pegel repräsentierenden Potential oder mit einem einen hohen Pegel repräsentierenden Potential verbunden. Es kann aber auch vorgesehen werden, daß sich der TESTCONTROL-Pegel statisch oder dynamisch einstellen läßt.

Die das Signal NORMCONTROL führende Leitung ist über eine Fuse F mit einem Potential verbunden,
- welches, wenn es (bei TEST = 0 und nicht zerstörter Fuse F) nach MUX1OUT durchgeschaltet wird, in den abhängig von diesem Signal arbeitenden Vergleichseinheiten bewirkt, daß die betreffenden Vergleichseinheiten deaktiviert werden, und
- dessen Ausbleiben (bei TEST = 0 und zerstörter Fuse F) in den abhängig vom Ausgangssignal MUX1OUT des Multiplexers MUX1 arbeitenden Vergleichseinheiten bewirkt, daß die betreffenden Vergleichseinheiten aktiviert werden.

Im betrachteten Beispiel wird das Signal MUX1OUT des Multiplexers MUX1 invertiert und anschließend einer logischen Verknüpfung (beispielsweise einer durch ein UND-Glied AND2 erfolgenden UND-Verknüpfung) mit dem jeweiligen Ausgangssignal des Komparators K4 der abhängig von MUX1OUT arbeitenden Vergleichseinheiten unterzogen, wobei das Ergebnis dieser logischen Verknüpfung anstelle des Ausgangssignals des Komparators K4 dem UND-Glied AND1 zugeführt wird; dies ist in Figur 3 dargestellt.

Wenn und so lange das vom Multiplexer MUX1 durchgeschaltete Signal den Pegel 1 hat, hat der Pegel des Ausgangssignals des UND-Gliedes AND2 und damit auch der Pegel des UND-Gliedes AND1 unabhängig vom Pegel des Ausgangssignals des Komparators K4 stets den Wert 0, wodurch die betreffende Vergleichseinheit außerstande ist, Übereinstimmungen der an die Speichereinrichtung angelegten Adresse mit der der Vergleichseinheit zugeordneten Referenzadresse zu signalisieren.

Wenn und so lange das vom Multiplexer MUX1 durchgeschaltete Signal den Pegel 0 hat, was bei zerstörter Fuse F der Fall ist, entspricht der Pegel des Ausgangssignals des UND-Gliedes AND2 dem Pegel des Ausgangssignals des Komparators K4, wodurch die betreffende Vergleichseinheit Übereinstimmungen der an die Speichereinrichtung angelegten Adresse mit der der Vergleichseinheit zugeordneten Referenzadresse signalisieren kann.

Auf diese Weise können die Vergleichseinheiten sowohl im Testbetrieb als auch im normalen Betrieb der Speichereinrichtung selektiv aktiviert und deaktiviert werden. Dabei kann die Aktivierung und Deaktivierung der Vergleichseinheiten im Testbetrieb unabhängig davon erfolgen, ob und gegebenenfalls welche Vergleichseinheiten im normalen Betrieb der Speichereinrichtung aktiviert oder deaktiviert sind; ob und gegebenenfalls welche Vergleichseinheiten aktiviert bzw. deaktiviert werden, hängt nämlich im Testbetrieb (TEST = 1) vom Signal TESTCONTROL, und im normalen Betrieb (TEST = 0) vom Signal NORMCONTROL ab, und diese Signale sind für jede Vergleichseinheit oder für mehrere Vergleichseinheiten umfassende Vergleichseinheiten-Gruppen (z.B. Vergleichseinheiten-Bänke) unabhängig voneinander festlegbar.

Die Speichereinrichtung ist so aufgebaut, daß deren Vergleichseinheiten nach der Herstellung der Speichereinrichtung (Fuse F der Aktivierungs-/Deaktivierungseinrichtung noch nicht zerstört) im Normalbetrieb der Speichereinrichtung nicht aktiviert sind. Die Vergleichseinheiten werden im Normalbetrieb vorzugsweise nur dann in Betrieb genommen, wenn sich bei einem Test der Speichereinrichtung herausstellt, daß nicht alle Speicherzellen ordnungsgemäß beschreibbar oder auslesbar sind. Die Inbetriebnahme der Vergleichseinheiten läßt sich durch ein Zerstören der Fuse F der der betreffenden Vergleichseinheit zugeordneten Aktivierungs-/Deaktivierungseinrichtung bewerkstelligen.

Beim Testen der Speichereinrichtung können die Vergleichseinheiten unabhängig voneinander nach Belieben aktiviert und deaktiviert werden; die Pegel der Signale TESTCONTROL der einzelnen Aktivierungs-/Deaktivierungseinrichtungen können unabhängig voneinander beliebig eingestellt und/oder verändert werden.

Dies wird im betrachteten Beispiel dahingehend ausgenutzt, daß insbesondere beim Testen derjenigen Bestandteile der Speichereinrichtung, unter Verwendung welcher sich nicht ordnungsgemäß beschreibbare oder auslesbare Speicherzellen oder Speicherzellenbereiche durch Ersatz-Speicherzellen oder Ersatz-Speicherzellenbereiche ersetzen lassen, nur sehr wenige ausgewählte Vergleichseinheiten aktiviert und getestet werden.

Vorzugsweise werden nur so viele und solche Vergleichseinheiten aktiviert,
- daß einerseits für jede an die Speichereinrichtung angelegte Adresse von den aktivierten Vergleichseinheiten maximal eine eine Übereinstimmung feststellen kann, und/oder
- daß andererseits die Speicherbereiche, denen die aktivierten Vergleichseinheiten durch deren Referenzadresse zugeordnet oder zuordenbar sind, alle Speicherzellen umfassen, die durch die an die Speichereinrichtung angelegten Adressen adressierbar sind.

Im betrachteten Beispiel wird dies dadurch realisiert, daß für jeden Speicherblock nur jeweils die Vergleichseinheiten von genau einer der dem betreffenden Speicherblock zugeordneten Vergleicheinheiten-Bänke aktiviert wird. D.h., von den jeweils vier Vergleichseinheiten-Bänken die jedem Speicherblock zugeordnet sind, wird genau eine Vergleichseinheiten-Bank ausgewählt, und von dieser einen Vergleichseinheiten-Bank pro Speicherblock werden jeweils alle Vergleichseinheiten aktiviert.

Dies erweist sich als vorteilhaft, weil dadurch ausgeschlossen ist, daß mehrere Vergleichseinheiten eine Übereinstimmung der der Speichereinrichtung zugeführten Adresse mit den den Vergleichseinheiten zugeordneten Referenzadressen signalisieren können, und weil sich dadurch der zum Testen zu treibende Aufwand minimal halten läßt.

Daß beim Testen insbesondere derjenigen Bestandteile der Speichereinrichtung, unter Verwendung welcher sich nicht ordnungsgemäß beschreibbare oder auslesbare Speicherzellen oder Speicherzellenbereiche durch Ersatz-Speicherzellen oder Ersatz-Speicherzellenbereiche ersetzen lassen, nur wenige ausgewählte Vergleichseinheiten aktiviert und getestet werden, bedeutet nicht, daß des Test unvollständig ist. Die Wahrscheinlichkeit, daß die vorhandenen Vergleichseinheiten teils fehlerbehaftet sind, und teils nicht fehlerbehaftet sind, ist vernachlässigbar gering. Wenn in integrierten Schaltungen wie der vorliegend betrachteten Speichereinrichtung Fehler auftreten, erstrecken diese sich in der Regel auf einen größeren Bereich oder auf alle Schaltungsteile mit identischem Aufbau, so daß aus der Fehlerfreiheit einzelner Vergleichseinheiten davon ausgegangen werden kann, daß auch die nicht getesteten (deaktivierten) Vergleichseinheiten fehlerfrei sind.

Das vorstehend bereits erwähnte Steuersignal TEST wird im betrachteten Beispiel nicht nur zum Steuern der Aktivierungs-/Deaktivierungseinrichtung verwendet. Es wird auch dazu verwendet, um festzulegen, ob die aktivierten Vergleichseinheiten die an die Speichereinrichtung angelegte Adresse mit den Adressen der nicht ordnungsgemäß beschreibbaren oder auslesbaren Speicherzellen oder Speicherzellenbereiche, oder mit einer zum Testen der Speichereinrichtung geeigneten oder benötigten Testadresse vergleichen (ob als Referenzadresse die Adressen der nicht ordnungsgemäß beschreibbaren oder auslesbaren Speicherzellen oder Speicherzellenbereiche oder Testadressen verwendet werden).

Im betrachteten Beispiel ist hierfür vorgesehen, daß das Eingangssignal Ref3 des Komparators K3 während des Testens der Speichereinrichtung aus einer anderen Signalquelle stammt als im normalen betrieb der Speichereinrichtung. Hierfür ist im betrachteten Beispiel ein vom Steuersignal TEST gesteuerter Multiplexer MUX2 vorgesehen. An den Eingangsanschlüssen dieses Multiplexers liegen die zugeordneten Bits der (unter Verwendung von Fuses F in der Speichereinrichtung registrierten) Adressen FAULTADR der nicht ordnungsgemäß beschreibbaren oder auslesbaren Speicherzellen oder Speicherzellenbereiche, und die zugeordneten Bits der Testadresse TESTADR an. Eine solche Anordnung ist in Figur 4 veranschaulicht.

Im betrachteten Beispiel ist die Testadresse TESTADR führenden Leitung dauerhaft mit einem einen niedrigen Pegel repräsentierenden Potential oder mit einem einen hohen Pegel repräsentierenden Potential verbunden. Es kann aber auch vorgesehen werden, daß sich die Testadresse TESTADR statisch oder dynamisch einstellen oder verändern läßt.

Bei TEST = 0, also im normalen Betrieb der Speichereinrichtung schaltet der Multiplexer MUX2 die an ihm anliegenden FAULTADR-Bits durch, wodurch die betreffende Vergleichseinheit die an der Speichereinrichtung anliegende Adresse mit einer der Adressen der nicht ordnungsgemäß beschreibbaren oder auslesbaren Speicherzellen oder Speicherzellenbereiche vergleicht. Bei TEST = 1, also beim Testen der Speichereinrichtung schaltet die Multiplexer MUX2 die an ihm anliegenden TESTADR-Bits durch, wodurch die betreffende Vergleichseinheit die an der Speichereinrichtung anliegende Adresse mit der der Vergleichseinheit zugeordneten Testadresse vergleicht.

Ein wie beschrieben beschalteter und betriebener Multiplexer MUX2 ist im betrachteten Beispiel allen Komparatoren K3 vorgeschaltet; es kann aber selbstverständlich auch vorgesehen werden, nur ausgewählten Komparatoren K3 einen solchen Multiplexer vorzuschalten.

Es dürfte einleuchten, daß auch die Referenzadressen Ref1, Ref2 und/oder Ref4 auf die beschriebene Art und Weise generierbar oder umschaltbar sind.

Damit können im Testbetrieb der Speichereinrichtung an diese angelegte Adressen mit frei wählbaren Testadressen verglichen werden, wobei die Festlegung dieser Testadressen völlig unabhängig von den den betreffenden Vergleichseinheiten im normalen Betrieb zugeordneten Adressen erfolgen kann.

Selbstverständlich können während des Testens der Speichereinrichtung zusätzlich oder alternativ auch beliebige andere Steuerungen oder Einstellungen der Vergleichseinheiten oder sonstiger Bestandteile der Speichereinrichtung wie beschrieben oder anders verändert werden.

Eine wie beschrieben aufgebaute Speichereinrichtung kann mit minimalem Aufwand zuverlässig getestet, konfiguriert und betrieben werden.

## Patentansprüche

1. Speichereinrichtung mit einer Vielzahl von Speicherzellen zum Speichern von Daten, und mit Vergleichseinheiten (VE), durch welche überprüfbar ist, ob einer an die Speichereinrichtung (S) angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt,
**dadurch gekennzeichnet,**
daß die Vergleichseinheiten während des Testens der Speichereinrichtung in einen Zustand versetzbar sind, der sich von dem Zustand, den die Vergleichseinheiten während des normalen Betriebes der Speichereinrichtung innehaben, unterscheidet.

2. Speichereinrichtung nach Anspruch 1,
**dadurch gekennzeichnet,**
daß die Vergleichseinheiten (VE) die an die Speichereinrichtung (S) angelegte Adresse mit den Vergleichseinheiten zugeordneten Referenzadressen vergleichen.

3. Speichereinrichtung nach Anspruch 2,
**dadurch gekennzeichnet,**
daß jeder Vergleichseinheit (VE) eine eigene Referenzadresse zugeordnet ist.

4. Speichereinrichtung nach Anspruch 2 oder 3,
**dadurch gekennzeichnet,**
daß die Vergleichseinheiten (VE) parallel arbeiten und die an die Speichereinrichtung (S) angelegte Adresse gleichzeitig mit allen Referenzadressen vergleichen.

5. Speichereinrichtung nach einem der Ansprüche 2 bis 4,
**dadurch gekennzeichnet,**
daß die Vergleichseinheiten (VE) durch die Referenzadressen jeweils einem bestimmten Speicherbereich der Speichereinrichtung (S) zugeordnet werden und durch die von ihnen durchgeführten Vergleiche überprüfen, ob die an die Speichereinrichtung angelegte Adresse innerhalb des Speicherbereichs liegt, dem sie jeweils zugeordnet sind.

6. Speichereinrichtung nach einem der Ansprüche 2 bis 5,
**dadurchgekennzeichnet,**
daß als Referenzadressen die Adressen der nicht ordnungsgemäß beschreibbaren oder auslesbaren Speicherzellen oder der nicht ordnungsgemäß beschreibbare oder auslesbare Speicherzellen enthaltenden Speicherzellenbereiche verwendet werden.

7. Speichereinrichtung nach einem der Ansprüche 2 bis 6,
**dadurchgekennzeichnet,**
daß als Referenzadressen zum Testen der Speichereinrichtung (S) geeignete Testadressen verwendet werden.

8. Speichereinrichtung nach Anspruch 7,
**dadurch gekennzeichnet,**
daß die Testadressen beim Testen der Speichereinrichtung (S) verwendet werden.

9. Speichereinrichtung nach Anspruch 8,
**dadurch gekennzeichnet,**
daß die Testadressen unabhängig von den Referenzadressen festlegbar sind, mit welchen die Vergleichseinheiten (VE) die an die Speichereinrichtung (S) angelegten Adressen sonst vergleichen.

10. Speichereinrichtung nach einem der vorhergehenden Ansprüche,
**dadurch gekennzeichnet,**
daß die Referenzadressen zumindest teilweise dauerhaft in der Speichereinrichtung registrierbar sind.

11. Speichereinrichtung nach Anspruch 10,
**dadurchgekennzeichnet,**
daß die Registrierung der zu registrierenden Adressen unter Verwendung von Fuses (F) erfolgt.

12. Speichereinrichtung nach einem der vorhergehenden Ansprüche,
**dadurchgekennzeichnet,**
daß während des Testens der Speichereinrichtung (S) nur ausgewählte Vergleichseinheiten (VE) aktiviert, und alle anderen Vergleichseinheiten deaktiviert werden.

13. Speichereinrichtung nach Anspruch 12,
**dadurchgekennzeichnet,**
daß die Vergleichseinheiten (VE) während des Testens der Speichereinrichtung (S) unabhängig davon, ob sie im normalen Betrieb der Speichereinrichtung aktiviert oder deaktiviert sind, aktivierbar und deaktivierbar sind.

14. Speichereinrichtung nach Anspruch 12 oder 13,
**dadurchgekennzeichnet,**
daß nur so viele und solche Vergleichseinheiten (VE) aktiviert werden, daß für jede an die Speichereinrichtung (S) angelegte Adresse von den aktivierten Vergleichseinheiten maximal eine eine Übereinstimmung feststellen kann.

15. Speichereinrichtung nach einem der Ansprüche 12 bis 14,
**dadurchgekennzeichnet,**
daß so viele und solche Vergleichseinheiten (VE) aktiviert werden, daß die Speicherbereiche, denen die aktivierten Vergleichseinheiten durch deren Referenzadresse zugeordnet oder zuordenbar sind, alle Speicherzellen umfassen, die durch die an die Speichereinrichtung (S) angelegten Adressen adressierbar sind.
